(19) Europäisches Patentamt
European Patent Office
Office européen des brevets

(11) **EP 3 172 354 B1**

(12) **EUROPÄISCHE PATENTSCHRIFT**

(45) Veröffentlichungstag und Bekanntmachung des Hinweises auf die Patenterteilung:
**25.04.2018 Patentblatt 2018/17**

(21) Anmeldenummer: **15739216.8**

(22) Anmeldetag: **10.07.2015**

(51) Int Cl.:
***C23C 14/34*** (2006.01)

(86) Internationale Anmeldenummer:
**PCT/EP2015/065800**

(87) Internationale Veröffentlichungsnummer:
**WO 2016/012268 (28.01.2016 Gazette 2016/04)**

(54) **SPUTTERTARGET AUF DER BASIS EINER SILBERLEGIERUNG**

SILVER-ALLOY BASED SPUTTERING TARGET

CIBLE DE PULVÉRISATION CATHODIQUE À BASE D'UN ALLIAGE D'ARGENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.07.2014 DE 102014214683**

(43) Veröffentlichungstag der Anmeldung:
**31.05.2017 Patentblatt 2017/22**

(73) Patentinhaber: **Materion Advanced Materials Germany GmbH**
**63450 Hanau (DE)**

(72) Erfinder:
• **SCHLOTT, Martin**
**63075 Offenbach (DE)**
• **HERZOG, Andreas**
**63486 Bruchköbel (DE)**
• **SCHOLL, Thomas**
**63110 Rodgau (DE)**
• **KONIETZKA, Uwe**
**63826 Geiselbach (DE)**

(74) Vertreter: **Pillep, Bernhard**
**Kador & Partner**
**Corneliusstrasse 15**
**80469 München (DE)**

(56) Entgegenhaltungen:
JP-A- 2010 049 726    US-A1- 2002 012 604
US-A1- 2004 028 912    US-A1- 2004 226 818
US-A1- 2006 169 577

**Beschreibung**

Die vorliegende Erfindung betrifft ein Sputtertarget, das eine Silberlegierung umfasst, sowie ein Herstellungsverfahren für dieses Sputtertarget.

Silber ist aufgrund seiner guten Reflexionseigenschaften ein gebräuchliches Beschichtungsmaterial im Bereich der optischen Datenspeicher, Display-Anwendungen und in der Optoelektronik. Abhängig von der Einsatzumgebung und weiteren angrenzenden Schichten neigt Silber zur Korrosion, was zur Beeinträchtigung der Reflexionseigenschaften und bis zum Ausfall des Bauteils führen kann.

Es ist bekannt, dass die Korrosionseigenschaften verbessert werden können, wenn dem Silber Legierungselemente zugegeben werden. So beschreibt beispielsweise die EP 2 487 274 A1 eine Silberlegierung, die bis zu 1,5 Gew% Indium enthält und eine mittlere Korngröße im Bereich von 150-400 $\mu$m aufweist. In der US 7,767,041 werden Bismuth-haltige Silberlegierungen beschrieben.

JP 2000-109943 beschreibt Silberlegierungen, die 0.5-4.9 Atom% Palladium enthalten.

EP 1 736 558 beschreibt eine Silberlegierung zur Verwendung als Reflexionsbeschichtung. Diese Silberlegierung enthält zumindest zwei Legierungselemente, wobei das erste Legierungselement Aluminium, Indium oder Zinn ist und das zweite Legierungselement aus einer Vielzahl weiterer metallischer Elemente ausgewählt werden kann.

Je höher die Menge des zugefügten Legierungselements, desto höher ist zwar einerseits die Korrosionsstabilität, andererseits nimmt auch das Risiko zu, dass die Reflexionseigenschaften nachteilig beeinflusst werden.

Prinzipiell können solche Reflexionsschichten über unterschiedliche Beschichtungsverfahren auf ein Substrat aufgebracht werden. Ein bevorzugtes Verfahren ist Sputtern, wobei Sputtertargets eingesetzt werden. Wie dem Fachmann bekannt ist, versteht man unter einem Sputtertarget das zu sputternde Material einer Kathodenzerstäubungsanlage.

Bei der chemischen Zusammensetzung des Sputtertargets sind die erwünschten Eigenschaften der herzustellenden Beschichtung zu berücksichtigen. Soll beispielsweise eine Reflexionsbeschichtung auf Silberbasis mit hoher Korrosionsstabilität über den Sputterprozess hergestellt werden, so kann das Sputtertarget aus einer Silberlegierung mit korrosionshemmenden Legierungselementen bestehen.

Ein wichtiges Kriterium, das ein Sputtertarget üblicherweise erfüllen sollte, ist eine sehr gleichmäßige Sputterrate, um so die Bildung einer Beschichtung mit einer möglichst geringen Schichtdickenschwankung zu ermöglichen. Durch hohe Schichtdickenschwankungen wird unter anderem auch das Reflexionsverhalten einer Silberbeschichtung nachteilig beeinflusst. Außerdem wird durch gleichmäßiges Sputterverhalten eine hohe Targetausnutzung gefördert und somit die Prozesseffizienz erhöht.

Weiterhin sollte ein geeignetes Sputtertarget eine Abscheidung bei möglichst geringer Arc-Rate ermöglichen. Als "Arcing" werden lokale Funkentladungen auf dem Sputtertarget bezeichnet. Durch die Funkenentladung wird das Sputtertargetmaterial lokal aufgeschmolzen und kleine Spritzer dieses aufgeschmolzenen Materials können auf das zu beschichtende Substrat gelangen und dort Defekte erzeugen.

Somit muss das Sputtertargetmaterial so beschaffen sein, dass es einerseits den erwünschten Endeigenschaften der aufzubringenden Beschichtung Rechnung trägt (z.B. gute Reflexionseigenschaften bei möglichst hoher Korrosionsstabilität), andererseits aber eine gleichmäßige Sputter-Rate und ein möglichst geringes Arcing aufweist, um die Schichtdickenschwankung und die Anzahl der Defekte in der Beschichtung zu minimieren. Eine Verbesserung des einen Aspekts (z.B. Optimierung der Schichteigenschaften hinsichtlich der geplanten Anwendung) sollte nicht auf Kosten des zweiten Aspekts (möglichst gute Sputtereigenschaften) erfolgen. In der Praxis zeigt sich aber häufig, dass es schwierig ist, beiden Aspekten gleichzeitig gerecht zu werden.

Eine Aufgabe der vorliegenden Erfindung besteht in der Bereitstellung eines Sputtertargets, mit dem sich eine möglichst korrosionsbeständige Reflexionsbeschichtung auf Silberbasis mit geringer Schichtdickenschwankung und bei geringer Arc-Rate herstellen lässt. Eine weitere Aufgabe der vorliegenden Erfindung besteht in der Bereitstellung eines geeigneten Verfahrens für die Herstellung eines solchen Sputtertargets.

Gelöst wird diese Aufgabe durch ein Sputtertarget gemäß Anspruch 1, umfassend eine Silberlegierung,

- die 5-25 Gew% Palladium, bezogen auf die Gesamtmenge der Silberlegierung, enthält, und
- eine mittlere Korngröße im Bereich von 25-90 $\mu$m aufweist.

Aufgrund des relativ hohen Anteils an Palladium in der Silberlegierung lässt sich mit dem erfindungsgemäßen Sputtertarget eine Reflexionsbeschichtung mit hoher Korrosionsstabilität herstellen. Im Rahmen der vorliegenden Erfindung wurde überraschend festgestellt, dass sich trotz des hohen Anteils an Palladium in der Silberlegierung des Sputtertargets eine sehr gleichmäßige Sputterrate und somit eine sehr geringe Schichtdickenschwankung in der abgeschiedenen Beschichtung realisieren lassen, wenn die Silberlegierung eine mittlere Korngröße im Bereich von 25-90 $\mu$m aufweist.

Bevorzugt enthält die Silberlegierung das Palladium in einer Menge von 7-23 Gew%, bevorzugter 9-21 Gew%.

In einer bevorzugten Ausführungsform enthält die Silberlegierung das Palladium in einer Menge von 7-13 Gew%. Alternativ kann es auch bevorzugt sein, dass die Silberlegierung das Palladium in einer Menge von 17-23 Gew% enthält. Diese Mengenangaben des Palladiums beziehen sich jeweils auf die Gesamtmenge der Silberlegierung.

Optional kann die Silberlegierung noch weitere Legierungselemente als unvermeidliche Verunreinigungen enthalten. Bei diesen unvermeidlichen Verunreinigungen kann es sich um metallische Verunreinigungen handeln. Bevorzugt werden diese unvermeidlichen Verunreinigungen so gering wie möglich gehalten und liegen in Summe bevorzugt in einer Menge von weniger als 0,5Gew%, bevorzugter weniger als 0,05 Gew% vor. Dies kann beispielsweise sicher gestellt werden, wenn bereits die Ausgangsmetalle, die für die Herstellung der Silberlegierung eingesetzt werden, eine ausreichend hohe Reinheit aufweisen. In einer bevorzugten Ausführungsform enthält die Silberlegierung 5-25 Gew% Palladium, während weitere metallische Elemente (z.B. als unvermeidliche Verunreinigungen) in der Summe in einer Menge von weniger als 0,5 Gew%, bevorzugter weniger als 0,05 Gew% oder sogar weniger als 0,01 Gew% in der Silberlegierung vorliegen. Die Mengenangaben beziehen sich auf das Gesamtgewicht der Silberlegierung.

In einer bevorzugten Ausführungsform liegt die mittlere Korngröße der Silberlegierung im Bereich von 30-85 $\mu$m, noch bevorzugter im Bereich von 35-70 $\mu$m.

Die Sputtereigenschaften der Silberlegierung können weiter optimiert werden, wenn die Körner der Silberlegierung ein bestimmtes Achsenverhältnis aufweisen. Die Körner der Silberlegierung weisen ein mittleres Achsenverhältnis von mindestens 60%, bevorzugter mindestens 70 % oder mindestens 75% oder sogar mindestens 85% auf. Bevorzugt beträgt das Achsenverhältnis der Körner maximal 100%.

Wie nachfolgend bei der Beschreibung der Messmethoden noch eingehender erläutert wird, werden für die Bestimmung des mittleren Korn-Achsenverhältnisses Höhe (maximale Abmessung eines Korns in Dickenrichtung (d.h. senkrecht zur Sputteroberfläche) des Sputtertargets) und Breite (maximale Abmessung eines Korns senkrecht zur Dickenrichtung bzw. parallel zur Sputteroberfläche) von Körnern bestimmt. Es wird für die Körner jeweils der Quotientenwert von Korn-Höhe zu Korn-Breite und schließlich der Mittelwert dieser Quotientenwerte errechnet (jeweils multipliziert mit 100 für die Angabe in %). Das Achsenverhältnis der einzelnen Körner (d.h. der Quotient aus Höhe und Breite der jeweiligen Körner) wird bestimmt an einem Schliff senkrecht zur Sputteroberfläche. Die Sputteroberfläche ist die Oberfläche, aus der durch Beschuss mit energiereichen Teilchen Atome herausgelöst werden.

Eine weitere Optimierung der Sputtereigenschaften der Silberlegierung kann außerdem erzielt werden, wenn die Körner der Silberlegierung eine möglichst geringe Variation (in %) der Korngröße aufweisen. Die Silberlegierung des Sputtertargets weist eine Variation der Korngröße von weniger als 15%, bevorzugter weniger als 11%, noch bevorzugter weniger als 9% oder sogar weniger als 7% auf.

Da die Silberlegierung des Sputtertargets ein kristallines Material ist, zeigen sich in der Röntgenbeugung entsprechend Röntgenbeugungsreflexe. Die Intensität der jeweiligen Röntgenbeugungsreflexe beschreibt Vorzugsorientierungen im Kristallgitter und Texturen der Legierung. In einer bevorzugten Ausführungsform beträgt die Variation des Verhältnisses der Intensität des zweitintensivsten Röntgenbeugungsreflexes zu der Intensität des intensivsten Röntgenbeugungsreflexes weniger als 35%, bevorzugter weniger als 25%. Es hat sich gezeigt, dass Silberlegierungen, die dieser Bedingung genügen, eine Kornorienterung aufweisen, die für eine gleichmäßige Sputterrate sehr vorteilhaft ist.

Bevorzugt weist die Silberlegierung des Sputtertargets einen Sauerstoffgehalt von weniger als 100 Gew.-ppm, bevorzugter weniger als 50 Gew.-ppm, noch bevorzugter weniger als 30 Gew.-ppm auf.

Bevorzugt besteht das Sputtertarget aus der oben beschriebenen Silberlegierung.

Je nach Anwendung kann die Geometrie des Sputtertargets variieren. Das Sputtertarget kann beispielsweise planar (z.B. in Form einer Scheibe oder einer Platte) oder rohrförmig sein.

In Abhängigkeit von der geplanten Anwendung können auch die Abmessungen des Sputtertargets über einen breiten Bereich variieren. Beispielsweise kann das planare Sputtertarget eine Fläche im Bereich von 0,5 m$^2$ bis 8 m$^2$ aufweisen. Das rohrförmige Sputtertarget kann beispielsweise eine Länge im Bereich von 0,5 bis 4 m aufweisen.

Sofern erforderlich, kann das Sputtertarget noch auf einem Substrat angebracht werden, z.B. auf einer Rückplatte. Die Anbindung ("bonding") des Sputtertargets an das Substrat kann beispielsweise mittels Lot (z.B. Indium) erfolgen. Auch formschlüssiges Anbringen auf einer Rückplatte ist möglich. Dies ist dem Fachmann grundsätzlich bekannt.

In einem weiteren Aspekt betrifft die vorliegende Erfindung ein Verfahren zur Herstellung des oben beschriebenen Sputtertargets gemäß Anspruch 3, in dem man eine Schmelze, die Silber und Palladium enthält, erstarren lässt, um einen Formkörper zu erhalten, der Formkörper auf eine Umformtemperatur von mindestens 200°C erwärmt wird und dann mindestens einem Umformschritt unterzogen wird, und der Formkörper außerdem mindestens einer Rekristallisation unterzogen wird.

Die Silber und Palladium enthaltende Schmelze kann über gängige, dem Fachmann bekannte Verfahren erzeugt werden, beispielsweise einem Schmelzofen (z.B. in einem Induktionsschmelzofen, insbesondere einem Vakuuminduktionsschmelzofen). Hierzu können Silbermetall und Palladiummetall in geeigneten Mengen (d.h. um eine Silberlegierung mit einem Pd-Anteil von 5-25 Gew% zu erhalten) in den Schmelzofen gegeben und aufgeschmolzen werden. Als Ausgangsmaterial kann auch eine Silberlegierung, die bereits Palladium als Legierungselement enthält, verwendet werden. Um die Menge an unerwünschten Verunreinigungen möglichst gering zu halten, kann es vorteilhaft sein, die Ausgangsmetalle bereits in ausreichend hoher Reinheit einzusetzen. Beispielsweise können das Silber und das Palladium jeweils in einer Reinheit von mindestens 99,5% eingesetzt werden. Der Schmelzvorgang wird üblicherweise unter Vakuum und/oder einer Inertgasatmosphäre (z.B. Argon) durchgeführt.

Anschließend kann die Schmelze in eine Form bzw. Kokille (z.B. eine Graphitform) gegossen werden. Lässt man die Schmelze in dieser Form abkühlen und erstarren, erhält man einen festen Formkörper.

Wie oben erwähnt, wird der Formkörper auf eine Umformtemperatur von mindestens 200°C erwärmt und dann mindestens einem Umformschritt unterzogen. Außerdem wird der Formkörper mindestens einer Rekristallisation unterzogen. Wie nachfolgend eingehender beschrieben wird, kann die Rekristallisation während des Umformens erfolgen. Es ist aber auch möglich, dass die Rekristallisation nach dem Umformen durchgeführt wird. Weiterhin ist möglich, dass sowohl während des Umformens als auch nach dem Umformen eine Rekristallisation durchgeführt wird.

Das Umformen kann beispielsweise durch Walzen, Schmieden, Stauchen, Strecken, Extrusion oder Pressen oder eine Kombination von zwei oder mehr dieser Umformprozesse erfolgen. Diese Umformprozesse sind dem Fachmann an sich bekannt.

Prinzipiell ist es im Rahmen des erfindungsgemäßen Verfahrens möglich, dass das Umformen nur in einem einzigen Umformschritt (z.B. Walzschritt) erfolgt. Alternativ kann es bevorzugt sein, dass mindestens zwei, bevorzugter mindestens 4 Umformschritte (bevorzugt Walzschritte) durchgeführt werden, z.B. 2-10 oder auch 4-8 Umformschritte (bevorzugt Walzschritte).

Werden zwei oder mehr Walzschritte durchgeführt, kann die Walzrichtung in jedem nachfolgenden Walzschritt der Walzrichtung des vorhergehenden Walzschritts entsprechen oder um etwa 180° gedreht sein. Alternativ ist es auch möglich, dass im Fall von zwei oder mehr Walzschritten ein Kreuzwalzen erfolgt, d.h. in jedem nachfolgenden Walzschritt wird die Walzrichtung gegenüber dem vorangegangenen Walzschritt jeweils um etwa 90° gedreht (entweder jeweils im Uhrzeigersinn oder jeweils entgegen dem Uhrzeigersinn). Es ist auch möglich, dass die Walzrichtung in jedem Walzschritt gegenüber dem vorangegangenen Walzschritt jeweils um etwa 360°/n gedreht wird (entweder jeweils im Uhrzeigersinn oder jeweils entgegen dem Uhrzeigersinn), wobei n die Anzahl der Walzschritte ist.

Im Rahmen der vorliegenden Erfindung hat es sich als vorteilhaft erwiesen, wenn jeder Umformschritt bei einer Umformrate $\varepsilon$ von mindestens $5,5\,s^{-1}$, bevorzugter mindestens $7,0\,s^{-1}$ durchgeführt wird. Die Obergrenze der Umformrate ist nicht kritisch. Allerdings kann es aus prozesstechnischen Gründen vorteilhaft sein, wenn die Umformrate einen Wert von $20\,s^{-1}$ oder auch $15\,s^{-1}$ nicht übersteigt.

Die mittlere Umformrate (d.h. im Fall von mehreren Umformschritten der Mittelwert aus den Umformraten) kann beispielsweise mindestens $3,2\,s^{-1}$, bevorzugter mindestens $5,5\,s^{-1}$, noch bevorzugter mindestens $7,0\,s^{-1}$ oder sogar mindestens $8,5\,s^{-1}$ betragen. Die Obergrenze der mittleren Umformrate ist nicht kritisch. Allerdings kann es aus prozesstechnischen Gründen vorteilhaft sein, wenn die mittlere Umformrate einen Wert von $20\,s^{-1}$ oder auch $15\,s^{-1}$ nicht übersteigt.

Wie dem Fachmann bekannt ist, berechnet sich die Umformrate gemäß der folgenden Gleichung:

$$\varepsilon = \frac{2\pi\,n}{60\sqrt{r'}}\cdot\sqrt{\frac{R}{H_0}}\cdot\ln\left(\frac{1}{1-r'}\right)$$

wobei

n die Umdrehungsgeschwindigkeit der Walze,
$H_0$ die Dicke des Formkörpers vor dem Walzschritt,
r' = r/100 mit r= Reduktion der Dicke des Formkörpers pro Walzschritt und R der Walzenradius

sind.

Aufgrund seines Fachwissens kann der Fachmann daher ohne weiteres einen Walzschritt so ausführen, dass eine vorgegebene Umformrate realisiert wird, indem die Dickenreduktion pro Walzschritt vorgegeben wird.

In dem erfindungsgemäßen Verfahren wird der Formkörper mindestens einer Rekristallisation unterzogen. Es kann sich dabei um eine dynamische oder statische Rekristallisation handeln. Wie dem Fachmann bekannt ist, erfolgt eine dynamische Rekristallisation während des Umformens. Während der statischen Rekristallisation erfolgt keine Umformung. Die Bestimmung der Rekristallisationstemperatur einer gegebenen Legierung unter bestimmten Verfahrensbedingungen ist für den Fachmann auf der Basis seines allgemeinen Fachwissens ohne weiteres möglich.

Bevorzugt wird der Formkörper mindestens einer dynamischen Rekristallisation (d.h. während des Umformens, also während der Formkörper einem oder mehrerer Umformschritte unterzogen wird) und mindestens einer statischen Rekristallisation unterzogen.

Bevorzugt beträgt die Umformtemperatur, auf die der Formkörper vor dem Umformen erwärmt wird, mindestens 500°C, bevorzugter mindestens 600°C oder sogar mindestens 700°C beträgt. Im Rahmen der vorliegenden Erfindung kann der Formkörper auch während des Umformens weiter aktiv (z.B. durch eine externe Wärmequelle) erwärmt werden. Wenn der Formkörper beim Umformen aber nicht signifikant abkühlt, ist ein weiteres aktives Erwärmen durch eine externe Wärmequelle während der Umformschritte nicht erforderlich.

Prinzipiell kann das erfindungsgemäße Verfahren auch einen oder mehrere Kaltumformungsschritte umfassen. Alternativ ist es möglich, dass das erfindungsgemäße Verfahren keine Kaltumformung umfasst.

Bevorzugt findet die statische Rekristallisation nach dem Umformen durch ein Glühen des umgeformten Formkörpers statt. Bevorzugt beträgt die Glühtemperatur mindestens 500°C, bevorzugter mindestens 600°C oder sogar mindestens 700°C beträgt. Die Zeitdauer des Glühens kann über einen breiten Bereich variieren. Beispielhaft kann eine Glühdauer von 0,5 bis 5 Stunden genannt werden.

Das Umformen und, sofern durchgeführt, die statische Rekristallisation nach dem Umformen können unter Vakuum, in einer Inertgasatmosphäre (z.B. Stickstoff) oder auch an Luft erfolgen.

Nach der statischen Rekristallisation (z.B. durch das oben beschriebene Glühen) kann man den Formkörper abkühlen lassen. Alternativ kann es bevorzugt sein, dass der Formkörper nach der statischen Rekristallisation abgeschreckt wird, beispielsweise durch Eintauchen in ein Wasserbad.

In einem weiteren Aspekt betrifft die vorliegende Erfindung die Verwendung des oben beschriebenen Sputtertargets für die Herstellung einer Reflexionsschicht.

Es kann sich beispielsweise um die Reflexionsschicht in einem Display bzw. Bildschirm handeln. Aufgrund der hohen Qualität und sehr geringen Schichtdickenschwankung kann die Reflexionsschicht auch in flexiblen Displays bzw. Bildschirmen eingesetzt werden.

Anhand der nachfolgenden Beispiele wird die Erfindung eingehender erläutert.

**Beispiele**

**I. Messmethoden**

Die Parameter, auf die in der vorliegenden Anmeldung Bezug genommen wird, werden mit den folgenden Messmethoden bestimmt:

Mittlere Korngröße

Die mittlere Korngröße M wurde im Linienschnittverfahren (DIN EN ISO 643) nach folgender Gleichung bestimmt:

$$M=(L*p)/(N*m)$$

wobei

    L: Länge der Messlinie
    p: Zahl der Messlinien
    N: Zahl der geschnittenen Körper
    m: Vergrößerung

Die Werte wurden an 3*3=9 verschiedenen Messstellen ermittelt in jeweils 3 Tiefen: 0 mm, 3 mm und 6 mm.

Variation der Korngröße

Aus den Korngrössen M kann die Variation gemäß den beiden folgenden Gleichungen (als Wert A1 oder alternativ als Wert B1) bestimmt werden:

$$A1=((M_{max} - M_{ave})/M_{ave}) * 100$$

$$B1=((M_{ave} - M_{min})/M_{ave}) * 100$$

mit

$M_{max}$: Maximaler Wert der Korngrößen
$M_{min}$: Minimaler Wert der Korngrößen
$M_{ave}$: Mittlere Korngröße

Im Rahmen der vorliegenden Anmeldung wird der höhere der beiden Werte (A1 oder B1) für die Festlegung der Korngrößenvariation herangezogen.

Mittleres Achsenverhältnis (in %) der Körner

Für die Bestimmung des mittleren Korn-Achsenverhältnisses werden Höhe (maximale Abmessung eines Korns in Dickenrichtung (d.h. senkrecht zur Sputteroberfläche) des Sputtertargets) und Breite (maximale Abmessung eines Korns senkrecht zur Dickenrichtung bzw. parallel zur Sputteroberfläche) von Körnern bestimmt. Es wird für die Körner jeweils der Quotientenwert von Korn-Höhe zu Korn-Breite und schließlich der Mittelwert dieser Quotientenwerte errechnet (jeweils multipliziert mit 100 für die Angabe in %).
Bei der Bestimmung von Höhe und Breite von Körnern wird folgendermaßen vorgegangen: Von dem Sputtertarget wird ein Schliff senkrecht zur Sputteroberfläche angefertigt. Auf diesem Schliff werden mindestens zwei Bereiche mit jeweils mindestens 40 Körnern ausgewählt. Für jedes dieser Körner wird dessen Höhe (d.h. maximale Abmessung bzw. Ausdehnung in Dickenrichtung des Sputtertargets) sowie dessen Breite (d.h. maximale Abmessung senkrecht zur Dickenrichtung) bestimmt. Dies erfolgt beispielsweise mit einem Lichtmikroskop mit Grössenskala oder mit einem Rasterelektronenmikroskop. Der Quotientenwert aus Höhe und Breite wird für jedes der Körner gebildet. Aus diesen Quotientenwerten wird der Mittelwert berechnet.

Variation des Intensitätsverhältnisses zwischen dem zweitintensivsten Röntgenbeugungsreflex und dem intensivsten Röntgenbeugungsreflex

Am Sputtertarget werden an 5 verschiedenen Stellen Röntgenbeugungsmessungen vorgenommen. $CuK_{\alpha 1}$-Strahlung, Zweikreisdiffraktometer mit Bragg-Brentano-Geometrie, Messfläche ca. 10 mm$^2$.
Für jede Röntgenbeugungsmessung werden die Intensität $I_2$ (nach Peakhöhe) des zweitintensivsten Beugungsreflexes und die Intensität $I_1$ (Peakhöhe) des intensivsten Beugungsrelexes bestimmt und aus diesen Werten das Intensitätsverhältnis $R=I_2/I_1$ gebildet.
Die Variation des Intensitätsverhältnisses kann gemäß den beiden folgenden Gleichungen (als Wert A2 oder alternativ als Wert B2) bestimmt werden:

$$A2=((R_{max} - R_{ave})/R_{ave}) * 100$$

$$B2=((R_{ave} - R_{min})/R_{ave}) * 100)$$

mit

$R_{max}$: Maximaler Wert der Intensitätsverhältnisse
$R_{min}$: Minimaler Wert der Intensitätsverhältnisse
$R_{ave}$: Mittelwert der Intensitätsverhältniswerte R

Im Rahmen der vorliegenden Anmeldung wird der höhere der beiden Werte (A2 oder B2) für die Festlegung der Variation des Röntgenbeugungsintensitätsverhältnisses herangezogen.

Sauerstoffgehalt

Der Sauerstoffgehalt wurde nach der Messmethode COHNS mit einer Apparatur der Firma Leco bestimmt.

**II. Herstellung von Sputtertargets**

Beispiel 1: Herstellung eines Sputtertargets bestehend aus einer Silberlegierung mit 20 Gew% Palladium

Silber und Palladium, jeweils mit einer Reinheit von 99,9%, wurden in Mengen entsprechend der vorgegebenen Endzusammensetzung in einen Vakuum-Induktionsschmelzofen gegeben und bei 1200°C und $10^{-1}$ mbar erschmolzen (Einwaagemasse: 3,5 kg). Die Schmelze wurde in eine Graphitform abgegossen und man ließ die Schmelze erstarren.
Der erhaltene Formkörper wurde auf 750°C (1 Stunde) vorgewärmt. Die Umformung erfolgte in 4 Walzschritten.
Die Dicke des Formkörpers vor dem Walzen und nach jedem Walzschritt sowie die jeweilige Dickenreduktion und Umformrate für jeden Walzschritt sind in der Tabelle 1 angegeben. Der Gesamtumformungsgrad betrug 60%.

Tabelle 1: Dicke, Dickenreduktion und Umformrate in Beispiel 1

| Walzschritt | Dicke [mm] | Dickenreduktion [mm] | Dickenreduktion [%] | Umformrate [1/s] |
|---|---|---|---|---|
| 0 (d.h. vor dem Walzen) | 20 | 0 | 0 | |
| 1 | 16 | 4 | 20,0 | 8,1 |
| 2 | 13 | 3 | 18,8 | 8,7 |
| 3 | 10 | 3 | 23,1 | 11,0 |
| 4 | 8 | 2 | 20,0 | 11,4 |

Wie bereits oben erwähnt, berechnet sich die Umformrate in bekannter Weise gemäß der folgenden Gleichung:

$$\varepsilon = \frac{2\pi\,n}{60\sqrt{r'}} \cdot \sqrt{\frac{R}{H_0}} \cdot \ln\left(\frac{1}{1-r'}\right)$$

wobei

n die Umdrehungsgeschwindigkeit der Walze,
$H_0$ die Dicke des Formkörpers vor dem Walzschritt,
r' = r/100 mit r= Reduktion der Dicke des Formkörpers pro Walzschritt und R der Walzenradius

sind.
In Beispiel 1 ergaben sich bei einer Walzengeschwindigkeit von 40 U/min und einem Walzenradius von 300 mm Umformraten für die jeweiligen Walzschritte von 8,1 bis 11,4 $s^{-1}$.
Die Umformgrade der jeweiligen Walzschritte lagen im Bereich von 18-23%.
Nach dem vierten Walzschritt erhielt man eine Platte von ca. 500*100*8 mm. Diese Platte wurde zur Rekristallisation bei 750°C 1 Stunde lang geglüht und anschließend in einem Wasserbad abgeschreckt.
Die Silberlegierung wies folgende Eigenschaften auf:

Mittlere Korngröße: 53 $\mu$m
Mittleres Achsenverhältnis der Körner: 90%
Variation der Korngröße: 5,6%
Variation des Intensitätsverhältnisses zwischen dem zweitintensivsten Beugungsreflex und dem
intensivsten Beugungsreflex: 21,7%
Sauerstoffgehalt: 12 Gew.-ppm

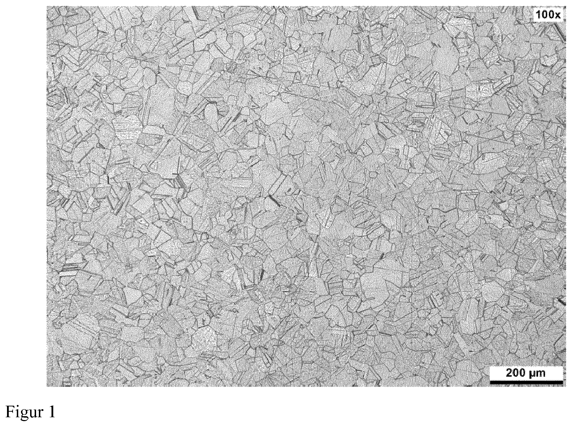

Figur 1 zeigt ein Anschliffbild (Schliff senkrecht zur Sputteroberfläche) der Silberlegierung. Die Aufnahme wurde mittels Lichtmikroskop angefertigt, nach Ätzen der Oberfläche mit $HNO_3$ bei 70°C.
Abschließend wurde die Platte mechanisch bearbeitet (Fräsen) und mit Indium gebondet. Vergleichsbeispiel 2: Herstellung eines Sputtertargets bestehend aus einer Silberlegierung mit 5 Gew% Palladium. Silber und Palladium wurden in Mengen entsprechend der vorgegebenen Endzusammensetzung in einen Vakuum-Induktionsschmelzofen gegeben und bei 1200°C und $10^{-1}$ mbar erschmolzen. Die Schmelze wurde in eine Graphitform abgegossen und man ließ die Schmelze erstarren.

Der erhaltene Formkörper wurde auf 250°C (1 Stunde) vorgewärmt. Die Umformung erfolgte in 8 Walzschritten.

Die Dicke des Formkörpers vor dem Walzen und nach jedem Walzschritt sowie die jeweilige Dickenreduktion und Umformrate für jeden Walzschritt sind in der Tabelle 2 angegeben.

Tabelle 2: Dicke, Dickenreduktion und Umformrate in Beispiel 2

| Walzschritt | Dicke [mm] | Dickenreduktion [mm] | Dickenreduktion [%] | Umformrate [1/s] |
|---|---|---|---|---|
| 0 (d.h. vor dem Walzen) | 20 | 0 | 0 | |
| 1 | 18 | 2 | 10,0 | 2,7 |
| 2 | 16 | 2 | 11,1 | 3,0 |
| 3 | 14,5 | 1,5 | 9,4 | 2,9 |
| 4 | 13 | 1,5 | 10,3 | 3,2 |
| 5 | 11,5 | 1,5 | 11,5 | 3,6 |
| 6 | 10 | 1,5 | 13,0 | 4,1 |
| 7 | 9 | 1 | 10,0 | 3,8 |
| 8 | 8 | 1 | 11,1 | 4,3 |

In Beispiel 2 lagen die Umformraten für die jeweiligen Walzschritte im Bereich von 2,7 bis 4,3 s$^{-1}$.

Die Umformgrade der jeweiligen Walzschritte lagen im Bereich von 9-13%.

Nach dem achten Walzschritt erhielt man eine Platte von ca. 500*100*8 mm. Diese Platte wurde zur Rekristallisation bei 750°C 1 Stunde lang geglüht und anschließend in einem Wasserbad abgeschreckt.

Die Silberlegierung wies folgende Eigenschaften auf:

| | |
|---|---|
| Mittlere Korngröße: | 49 μm |
| Mittleres Achsenverhältnis der Körner: | 83% |
| Variation der Korngröße: | 8,2% |

Abschließend wurde die Platte mechanisch bearbeitet und mit Indium gebondet.

Beispiel 3: Herstellung eines Sputtertargets bestehend aus einer Silberlegierung mit 10 Gew% Palladium

Silber und Palladium wurden in Mengen entsprechend der vorgegebenen Endzusammensetzung in einen Vakuum-Induktionsschmelzofen gegeben und bei 1200°C und 10$^{-1}$ mbar erschmolzen (Einwaagemasse: 1,8 kg). Die Schmelze wurde in eine Graphitkokille mit runder Kavität (d.h. Scheibenform) abgegossen und man ließ die Schmelze erstarren.

Der erhaltene Formkörper wurde auf 900°C (1 Stunde) vorgewärmt. Die Umformung erfolgte in 4 Walzschritten. Es wurde ein Kreuzwalzen durchgeführt, d.h. nach jedem Walzschritt erfolgte eine Rotation des Formkörpers um 90° im Uhrzeigersinn.

Die Dicke des Formkörpers vor dem Walzen und nach jedem Walzschritt sowie die jeweilige Dickenreduktion und Umformrate für jeden Walzschritt sind in der Tabelle 3 angegeben.

Tabelle 3: Dicke, Dickenreduktion und Umformrate in Beispiel 3

| Walzschritt | Dicke [mm] | Dickenreduktion [mm] | Dickenreduktion [%] | Umformrate [1/s] |
|---|---|---|---|---|
| 0 (d.h. vor dem Walzen) | 20 | 0 | 0 | |
| 1 | 16 | 4 | 20,0 | 8,1 |
| 2 | 13 | 3 | 18,8 | 8,7 |
| 3 | 10 | 3 | 23,1 | 11,0 |
| 4 | 8 | 2 | 20,0 | 11,4 |

Nach dem vierten Walzschritt erhielt man eine Scheibe von ca. 160*8 mm.

Ein abschließendes Glühen zur Rekristallisation wurde nicht durchgeführt.

Die Silberlegierung wies folgende Eigenschaften auf:

| | |
|---|---|
| Mittlere Korngröße: | 59 $\mu$m |
| Achsenverhältnis der Körner: | 62% |
| Variation der Korngröße: | 14% |

Abschließend wurde die Platte mechanisch bearbeitet und mit Indium gebondet.

Beispiel 4: Herstellung eines Sputtertargets bestehend aus einer Silberlegierung mit 15 Gew% Palladium

Silber und Palladium wurden in Mengen entsprechend der vorgegebenen Endzusammensetzung in einen Vakuum-Induktionsschmelzofen gegeben und bei 1200°C und $10^{-1}$ mbar erschmolzen (Einwaagemasse: 1,8 kg). Die Schmelze wurde in eine Graphitkokille mit runder Kavität (d.h. Scheibenform) abgegossen und man ließ die Schmelze erstarren.

Der erhaltene Formkörper wurde auf 750°C (1 Stunde) vorgewärmt. Die Umformung erfolgte in 4 Walzschritten. Es wurde ein Kreuzwalzen durchgeführt, d.h. nach jedem Walzschritt erfolgte eine Rotation des Formkörpers um 90° im Uhrzeigersinn.

Die Dicke des Formkörpers vor dem Walzen und nach jedem Walzschritt sowie die jeweilige Dickenreduktion und Umformrate für jeden Walzschritt sind in der Tabelle 4 angegeben.

Tabelle 4: Dicke, Dickenreduktion und Umformrate in Beispiel 4

| Walzschritt | Dicke [mm] | Dickenreduktion [mm] | Dickenreduktion [%] | Umformrate [1/s] |
|---|---|---|---|---|
| 0 (d.h. vor dem Walzen) | 20 | 0 | 0 | |
| 1 | 16 | 4 | 20,0 | 8,1 |
| 2 | 13 | 3 | 18,8 | 8,7 |
| 3 | 10 | 3 | 23,1 | 11,0 |
| 4 | 8 | 2 | 20,0 | 11,4 |

Nach dem vierten Walzschritt erhielt man eine Scheibe von ca. 160*8 mm. Diese Platte wurde zur Rekristallisation bei 800°C 1,5 Stunden lang geglüht und anschließend in einem Wasserbad abgeschreckt.

Die Silberlegierung wies folgende Eigenschaften auf:

| | |
|---|---|
| Mittlere Korngröße: | 60 $\mu$m |
| Achsenverhältnis der Körner: | 80% |
| Variation der Korngröße: | 10% |

Abschließend wurde die Platte mechanisch bearbeitet und mit Indium gebondet.

Vergleichsbeispiel 1: Herstellung eines Sputtertargets bestehend aus einer Silberlegierung mit 20 Gew% Palladium

Silber und Palladium wurden in Mengen entsprechend der vorgegebenen Endzusammensetzung in einen Vakuum-Induktionsschmelzofen gegeben und bei 1200°C und $10^{-1}$ mbar erschmolzen. Die Schmelze wurde in eine Graphitform abgegossen und man ließ die Schmelze erstarren.

Der erhaltene Formkörper nicht vorgewärmt. Die Umformung erfolgte als Kaltwalzen in 10 Walzschritten.

Die Dicke des Formkörpers vor dem Walzen und nach jedem Walzschritt sowie die jeweilige Dickenreduktion und Umformrate für jeden Walzschritt sind in der Tabelle 5 angegeben.

Tabelle 5: Dicke, Dickenreduktion und Umformrate im Vergleichsbeispiel 1

| Walzschritt | Dicke [mm] | Dickenreduktion [mm] | Dickenreduktion [%] | Umformrate [1/s] |
|---|---|---|---|---|
| 0 (d.h. vor dem Walzen) | 20 | - | - | - |
| 1 | 18,5 | 1,5 | 7,5 | 2,3 |

(fortgesetzt)

| Walzschritt | Dicke [mm] | Dickenreduktion [mm] | Dickenreduktion [%] | Umformrate [1/s] |
|---|---|---|---|---|
| 2 | 17 | 1,5 | 8,1 | 2,5 |
| 3 | 15,5 | 1,5 | 8,8 | 2,7 |
| 4 | 14 | 1,5 | 9,7 | 3,0 |
| 5 | 13 | 1 | 7,1 | 2,7 |
| 6 | 12 | 1 | 7,7 | 2,9 |
| 7 | 11 | 1 | 8,3 | 3,2 |
| 8 | 10 | 1 | 9,1 | 3,5 |
| 9 | 9 | 1 | 10,0 | 3,8 |
| 10 | 8 | 1 | 11,1 | 4,3 |

In Beispiel 2 lagen die Umformraten für die jeweiligen Walzschritte im Bereich von 2,3 bis 4,3 s$^{-1}$.

Nach dem zehnten Walzschritt erhielt man eine Platte von ca. 500*100*8 mm.

Die Silberlegierung wies folgende Eigenschaften auf:

| | |
|---|---|
| Mittlere Korngröße: | 95 $\mu$m |
| Achsenverhältnis der Körner: | <50% |
| Variation der Korngröße: | >18% |

Abschließend wurde die Platte mechanisch bearbeitet und mit Indium gebondet.

Bestimmung der Schichtdickengleichförmigkeit von Reflexionsbeschichtungen

Mit dem in Beispiel 1 hergestellten Sputtertarget (Palladiumgehalt von 20 Gew%) wurde eine Beschichtung auf ein Glassubstrat gesputtert (bei 500V DC, 0,2 A, 100W). Die Schicht zeigte eine Schichtdickenabweichung von weniger als 5%, gemessen an 10 Punkten des Glassubstrats. Die Arc-Rate lag deutlich unter 1 $\mu$arc/h.

Mit dem in Vergleichsbeispiel 1 hergestellten Sputtertarget (Palladiumgehalt von 20 Gew%) wurde ebenfalls eine Beschichtung auf ein Glassubstrat gesputtert (bei 500V DC, 0,2 A, 100W). Die Schicht zeigte eine Schichtdickenabweichung von mehr 10%, gemessen an 10 Punkten des Glassubstrats.

Wie aus den Beispielen ersichtlich ist, lassen sich mit den erfindungsgemäßen Sputtertargets Reflexionsbeschichtungen mit sehr konstanter Schichtdicke herstellen. Auch die Arc-Rate kann sehr niedrig gehalten werden. Da die Sputtertargets außerdem einen relativ hohen Palladiumanteil aufweisen, ist eine sehr gute Korrosionsbeständigkeit gewährleistet.

**Patentansprüche**

1. Sputtertarget, umfassend eine Silberlegierung, die

   - aus 5-25 Gew% Palladium, bezogen auf die Gesamtmenge der Silberlegierung,
   - weniger als 0,5 Gew% unvermeidlicher Verunreinigungen, sowie
   - dem verbleibenden Anteil aus Silber besteht, sowie
   - eine mittlere Korngröße im Bereich von 25-90 $\mu$m aufweist,
   - eine Variation der Korngröße von weniger als 15% aufweist und
   - deren Körner ein mittleres Achsenverhältnis von mindestens 60% aufweisen.

2. Sputtertarget nach Anspruch 1, wobei die Silberlegierung eine Variation des Intensitätsverhältnisses zwischen dem zweitintensivsten Röntgenbeugungsreflex und dem intensivsten Röntgenbeugungsreflex von weniger als 35% aufweist, und/oder die Silberlegierung einen Sauerstoffgehalt von weniger als 100 Gew.-ppm aufweist.

3. Verfahren zur Herstellung des Sputtertargets gemäß einem der Ansprüche 1 oder 2, wobei

- man eine Schmelze, die Silber und Palladium enthält, erstarren lässt, um einen Formkörper zu erhalten,
- der Formkörper auf eine Umformtemperatur von mindestens 200 °C erwärmt wird und dann mindestens einem Umformschritt unterzogen wird, und der Formkörper außerdem mindestens einer Rekristallisation unterzogen wird, und
- jeder Umformschritt bei einer Umformrate von mindestens 5,5 s$^{-1}$ durchgeführt wird.

4. Verfahren nach Anspruch 3, wobei der Umformschritt ein Walzen, ein Schmieden, ein Stauchen, ein Strecken, eine Extrusion oder ein Pressen ist.

5. Verfahren nach Anspruch 4, wobei das Walzen ein Kreuzwalzen ist.

6. Verfahren nach einem der Ansprüche 3-5, wobei der Formkörper mindestens einer dynamischen Rekristallisation und/oder mindestens einer statischen Rekristallisation unterzogen wird.

7. Verfahren nach Anspruch 6, wobei die dynamische Rekristallisation während des Umformens stattfindet, und/oder die statische Rekristallisation nach dem letzten Umformschritt erfolgt.

8. Verfahren nach einem der Ansprüche 3-7, wobei die Umformtemperatur, auf die der Formkörper vor dem ersten Umformschritt erwärmt wird, mindestens 500 °C beträgt, und/oder die statische Rekristallisation nach dem letzten Umformschritt durch ein Glühen bei einer Glühtemperatur von mindestens 500 °C erfolgt.

9. Das Verfahren nach einem der Ansprüche 6-8, wobei der Formkörper nach der statischen Rekristallisation abgeschreckt wird.

10. Verwendung des Sputtertargets nach einem der Ansprüche 1 oder 2 für die Herstellung einer Reflexionsschicht.

11. Verwendung nach Anspruch 10, wobei die Reflexionsschicht in einem Display, bevorzugt einem flexiblen Display vorliegt.

## Claims

1. Sputtering target comprising a silver alloy, consisting of

    - 5-25 wt.% of palladium, based on the total amount of the silver alloy,
    - less than 0.5 wt.% of unavoidable impurities, and
    - the remaining portion of silver, and
    - having a mean grain size in the range of 25-90 $\mu$m,
    - having a variation of grain size of less than 15 %, and
    - the grains of the silver alloy have a mean axial ratio of at least 60 %.

2. Sputtering target according to claim 1, wherein the silver alloy has a variation of the intensity ratio between the secondmost intensive X-ray diffraction reflection and the most intensive X-ray diffraction reflection of less than 35 %, and/or the silver alloy has an oxygen content of less than 100 ppm by weight.

3. Process for producing the sputtering target according to one of claims 1 or 2, wherein

    - a melt containing silver and palladium is allowed to solidify in order to obtain a shaped body,
    - the shaped body is heated to a forming temperature of at least 200 °C and then subjected to at least one forming step, and the shaped body is in addition subjected to at least one recrystallization, and
    - each forming step is carried out at a forming rate of at least 5.5 s$^{-1}$.

4. Process according to claim 3, wherein the forming step is a rolling, a forging, a swaging, a stretching, an extrusion or a pressing.

5. Process according to claim 4, wherein the rolling is a cross-rolling.

6. Process according to one of claims 3-5, wherein the shaped body is subjected to at least one dynamic recrystallization and/or at least one static recrystallization.

7. Process according to claim 6, wherein the dynamic recrystallization takes place during the forming, and/or the static recrystallization proceeds after the last forming step.

8. Process according to one of claims 3-7, wherein the forming temperature to which the shaped body is heated before the first forming step is at least 500 °C, and/or the static recrystallization after the last forming step proceeds via an annealing at an annealing temperature of at least 500 °C.

9. Process according to one of claims 6-8, wherein the shaped body is quenched after the static recrystallization.

10. Use of the sputtering target according to one of claims 1 or 2 for the production of a reflection layer.

11. Use according to claim 10, wherein the reflection layer is present in a display, preferably a flexible display.


**Revendications**

1. Cible pour pulvérisation cathodique, comprenant un alliage d'argent, constitué

   - de 5 à 25 % en poids de palladium par rapport au poids total de l'alliage d'argent,
   - de moins de 0,5 % en poids d'impuretés inévitables, ainsi que
   - d'argent pour la partie restante, et présentant
   - une granulométrie moyenne comprise dans la plage de 25 à 90 $\mu$m,
   - une variation de la granulométrie inférieure à 15 %, et
   - des grains dont le rapport moyen entre axes est d'au moins 60 %.

2. Cible pour pulvérisation cathodique selon la revendication 1, dans laquelle l'alliage d'argent présente une variation du rapport entre intensités, entre la réflexion la deuxième plus intense par diffraction aux rayons X et la réflexion la plus intense par diffraction aux rayons X, inférieur à 35 %, et/ou l'alliage d'argent présentant une teneur en oxygène inférieure à 100 ppm en poids.

3. Procédé de fabrication de la cible pour pulvérisation cathodique selon l'une des revendications 1 ou 2, dans lequel

   - on laisse se solidifier une masse fondue contenant de l'argent et du palladium, pour obtenir un objet moulé,
   - on chauffe l'objet moulé à une température de façonnage d'au moins 200 °C, puis on le soumet à une étape de façonnage, et on soumet en outre l'objet moulé à au moins une recristallisation, et
   - on met en oeuvre chaque étape de façonnage pour un taux de façonnage d'au moins 5,5 s$^{-1}$.

4. Procédé selon la revendication 3, dans lequel l'étape de façonnage est un laminage, un forgeage, un refoulement, un étirage, une extrusion ou un pressage.

5. Procédé selon la revendication 4, dans lequel le laminage est un laminage transversal.

6. Procédé selon l'une des revendications 3 à 5, dans lequel l'objet moulé est soumis à au moins une recristallisation dynamique et/ou au moins à une recristallisation statique.

7. Procédé selon la revendication 6, dans lequel la recristallisation dynamique a lieu pendant le façonnage et/ou la recristallisation statique a lieu après la dernière étape de façonnage.

8. Procédé selon l'une des revendications 3 à 7, dans lequel la température de façonnage à laquelle l'objet moulé est chauffé avant la première étape de façonnage est d'au moins 500 °C, et/ou la recristallisation statique a lieu après la dernière étape de façonnage par un recuit à une température de recuit d'au moins 500 °C.

9. Procédé selon l'une des revendications 6 à 8, dans lequel l'objet moulé est étiré après la recristallisation statique.

10. Utilisation de la cible pour pulvérisation cathodique selon l'une des revendications 1 ou 2 pour la fabrication d'une couche réfléchissante.

11. Utilisation selon la revendication 10, la couche réfléchissante étant présente dans un dispositif d'affichage, de préférence un dispositif d'affichage souple.

Figur 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2487274 A1
- US 7767041 B
- JP 2000109943 A
- EP 1736558 A